# EUROPÄISCHE PATENTSCHRIFT

(11) **EP 1 845 075 B1**
(45) Veröffentlichungstag und Bekanntmachung des Hinweises auf die Patenterteilung: **06.04.2016**
(21) Anmeldenummer: 06007572.8
(22) Anmeldetag: 11.04.2006
(51) Int. Cl.: C04B 35/83, F16D 69/02

(54) **Formkörper aus carbonfaserverstärktem Kohlenstoff und ein Verfahren zur deren Herstellung**
Carbon fibre reinforced carbon bodies and a method for their production
Corps en carbone renforcés par des fibres en carbone et un procédé pour fabriquer lesmêmes.

(43) Veröffentlichungstag der Anmeldung: 17.10.2007
(73) Patentinhaber: SGL Carbon SE, 65201 Wiesbaden (DE)
(72) Erfinder: Krätschmer, Ingrid, 86485 Biberach (DE); Kienzle, Andreas, Dr., 86753 Möttingen OT Balgheim (DE)

(56) Entgegenhaltungen:
- EP-A- 1 514 858
- US-A- 4 026 998
- US-A- 5 242 746

## Beschreibung

Die vorliegende Erfindung betrifft ein Verfahren zur Herstellung von Formkörpern, z.B. Bremsscheiben aus mit Carbon-Kurzfasern verstärktem Kohlenstoff.

Verbundwerkstoffe umfassend eine mit Carbonfasern verstärkte Kohlenstoffmatrix (CFRC-Werkstoffe), auch als Kohlenstoff/Kohlenstoff-Verbundwerkstoffe (C/C-Werkstoffe) bezeichnet, zeichnen sich durch hohe mechanische und thermische Belastbarkeit aus. Daher stellen diese Verbundwerkstoffe u.a. ein geeignetes Material für Hochleistungsbremsen, z.B. für Flugzeuge oder im Rennsport, dar.
Die verstärkenden Carbonfasern liegen oft in Form flächiger oder dreidimensionaler textiler Gebilde, beispielsweise als Gewebe oder vemadelte Preforms vor. Beide Varianten sind jedoch relativ aufwändig in der Herstellung und nur begrenzt anpassungsfähig an komplexe Geometrien.
Eine Alternative besteht darin, die Faserverstärkung aus losen Kurzfasern oder/und Kurzfaserbündeln auszubilden.
In der Patentschrift US 5,242,746 wird ein mehrere verschiedene Funktionsschichten umfassendes Reibelement aus carbonfaserverstärktem Kohlenstoff offenbart. Das Reibelement umfasst mindestens eine typischerweise 10 bis 20 mm dicke Strukturschicht, die sich durch hohe mechanische Festigkeit auszeichnet, und mindestens eine typischerweise 3 bis 7 mm dicke Reibschicht mit vorteilhaften tribologischen Eigenschaften und hoher Abriebfestigkeit.
Die Faserverstärkung der Strukturschicht ist von relativ grober Textur und wird durch bündelartige Segmente von Filamentsträngen (Rovings) gebildet, wobei die Segmente eine mittlere Länge zwischen 5 und 60 mm haben und 1.000 und 320.000 nahezu parallel ausgerichtete Einzelfilamente umfassen. Die Filamentstränge, die zu Bündeln geschnitten werden, können vorimprägniert sein, um das Zerfallen der Bündel zu vermeiden.
Die Faserverstärkung der Reibschicht ist von feiner Textur und wird von zerkleinerten Einzelfilamenten oder Bündeln von weniger als 100 Einzelfilamenten mit einer mittleren Länge zwischen 0,05 und 60 mm, vorzugsweise zwischen 0,2 und 2 mm gebildet.
Die Faserbündel in der Strukturschicht sind ebenso wie die Einzelfasem in der Reibschicht zufällig verteilt. Zwischen den beiden Schichten besteht ein kontinuierlicher Übergang in der Textur der Faserverstärkung und der Kohlenstoffinatrix, so dass die Schichten ein einstückiges Bauteil bilden.

Werden wie in US 5,242,746 vorgeschlagen die Faserbündel durch Schneiden von Filamentsträngen hergestellt, so kann durch Vorimprägnieren der Filamentstränge zwar das Zerfallen der Bündel vermindert werden. Jedoch sind die so erhaltenen Bündel nur durch die mittlere Länge und die Anzahl der einzelnen Filamente definiert, d.h. sie haben keine definierte, gezielt einstellbare Breite (Dimension senkrecht zur Längenausdehnung der Fasern, abhängig von der Anzahl nebeneinander liegender Fasern) und Dicke (Dimension senkrecht zu Länge und Breite, abhängig von der Anzahl übereinander liegender Fasern). In den Filamentsträngen können die Einzelfilamente nämlich sowohl neben- als auch übereinander liegen, und ihre Anordnung hängt stark von den äußeren Bedingungen (Druck, Zug, Scherkraft beim Mischen usw.) ab, denen der Filamentstrang bzw. die daraus geschnittenen Segmente unterworfen sind, bis die Imprägnierung soweit gehärtet ist, dass sie die Filamente in ihrer zu diesem Zeitpunkt vorliegenden Anordnung fixiert.

Mit der vorliegenden Erfindung wird ein Verfahren zur Herstellung von Formkörpern aus einer Kohlenstoffmatrix mit Verstärkung aus Carbonfasern (C/C-Formkörper) bereitgestellt, das es ermöglicht, die Verstärkung aus Faserbündeln mit definierten Dimensionen auszubilden, wobei der Zusammenhalt und die parallele räumliche Anordnung der Fasern in den Bündeln beim Einmischen in die Formmasse erhalten bleiben. Die definierte Anordnung der Fasern in den Bündeln erlaubt eine gezielte Anordnung der Verstärkungsfasern in der Kohlenstoffmatrix, und somit eine belastungsgeiechte Auslegung der Verstärkung.

Das erfindungsgemäße Verfahren zur Herstellung von Formkörper, speziell Bremsscheiben, aus mit Carbon-Kurzfaserbündeln verstärkter Kohlenstoffmatrix umfasst die folgenden Schritte
- Her- oder Bereitstellen von Bündeln aus durch einen formstabil gehärteten, carbonisierbaren Binder zusammengehaltenen, parallel ausgerichteten Carbonfasern, wobei die Herstellung der Faserbündel erfolgt durch Tränken mindestens eines Filamentstrangs, der eine Vielzahl paralleler Carbonfaser-Filamente umfasst, mit einem carbonisierbaren Binder, so dass ein Prepreg erhalten wird und Pressen mindestens eines imprägnierten Filamentstrangs oder mehrerer parallel angeordneter imprägnierter Filamentstränge zu einer Gelegebahn aus parallel orientierten Filamenten (unidirektionales Gelege, im folgenden als UD-Gelege bezeichnet) mit einer definierten Dicke, dabei Härten des Binders durch Wärmebehandlung, so dass eine formstabile
- Gelegebahn definierter Dicke erhalten wird und Schneiden der ggf. in einzelne Bänder aufgetrennten UD-Gelegebahn zu Segmenten (Faserbündeln) definierter Breite und Länge und wobei die Bündel eine gezielt eingestellte, definierte Länge, Breite und Dicke haben
- Herstellung einer Formmasse durch Mischen der Faserbündel, eines carbonisierbaren Matrixbildners und optionaler Hilfsstoffe
- Herstellung eines endkonturnahen Grünkörpers durch Verpressen der Formmasse in einem endkonturnahen Presswerkzeug bei erhöhter Temperatur unter Aushärten des carbonisierbaren Matrixbildners, anschließendes Entformen
- Carbonisierung des Grünkörpers zu einem carbonisieren Formkörper
- mechanische Nachbearbeitung des carbonisierten Formkörpers, falls erforderlich
- optionale Nachimprägnierung des carbonisierten Formkörpers mit einem carbonisierbaren Matrixbildner und Carbonisierung
- Verdichtung des carbonisierten Formkörpers durch Abscheidung einer Kohlenstoffmatrix mittels CVI-Verfahren

Gemäß einer zweiten Variante der Erfindung umfasst das Verfahren folgende Schritte:
- Her- oder Bereitstellen von Bündeln aus durch einen carbonisierten Binder zusammengehaltenen, parallel ausgerichteten Carbonfasern, wobei die Bündel eine gezielt eingestellte, definierte Länge, Breite und Dicke haben
- Imprägnieren der Faserbündel mit einem carbonisierbaren Matrixbildner in einem mechanisch erzeugten Wirbelbett
- Herstellung einer Formmasse durch Mischen der imprägnierten Faserbündel, eines carbonisierbaren Matrixbildners und optionaler Hilfsstoffe
- Herstellung eines endkonturnahen Grünkörpers durch Verpressen der Formmasse in einem endkonturnahen Presswerkzeug bei erhöhter Temperatur unter Aushärten des carbonisierbaren Matrixbildners, anschließendes Entformen
- Carbonisierung des Grünkörpers zu einem carbonisierten Formkörper
- mechanische Nachbearbeitung des carbonisierten Formkörpers, falls erforderlich
- optionale Nachimprägnierung des carbonisierten Formkötpers mit einem carbonisierbaren Matrixbildner und Carbonisierung
- Verdichtung des carbonisierten Formkörpers durch Abscheidung einer Kohlenstoffmatrix mittels CVI-Verfahren

Bei dieser Verfahrensweise werden die Faserbündel durch die Imprägnierung im Wirbelbett verdichtet. Der Grünkörper aus der Formmasse mit imprägnierten Faserbündeln und der daraus erhaltene carbonisierte Formkörper sind daher höher verdichtet als in der ersten Verfahrensvariante. Daher ist bei der zweiten Verfahrensvariante die für die Verdichtung des carbonisierten Formmkörpers mittels CVI-Abscheidung benötigte Zeit geringer.

Weitere Details, Varianten und Vorteile der Erfindung können der folgenden ausführlichen Beschreibung, dem Ausführungsbeispiel und den Figuren entnommen werden.
Figur 1 zeigt schematisch die Befüllung eines Werkzeugs für die Herstellung einer Bremsscheibe mit tangentialer Ausrichtung der Faserbündeln.
Figur 2 zeigt schematisch das Werkzeug mit Befüllgitter.
Figur 3 zeigt schematisch die durch das Befüllgitter eingestellte tangentiale Anordnung der Fasern im Werkzeug.

Unter Carbonfasern sind alle Arten von Carbonfasern zu verstehen, unabhängig vom Ausgangsmaterial, wobei Polyacrylnitril-, Pech- und Cellulosefasern die gebräuchlichsten Ausgangsmaterialien sind.

Ein Verfahren zur Herstellung von Faserbündeln definierter Länge, Breite und Dicke, umfassend parallel ausgerichtete Carbonfasern und einen formstabil gehärteten polymeren Binder ist in der europäischen Patentanmeldung EP 1 645 671 offenbart. In seiner für die vorliegende Erfindung adaptierten Variante umfasst dieses Verfahren folgende Schritte:
- Tränken mindestens eines Filamentstrangs, der eine Vielzahl paralleler Carbonfaser-Filamente umfasst, mit einem carbonisierbaren Binder, so dass ein Prepreg erhalten wird
- Pressen mindestens eines imprägnierten Filamentstrangs oder mehrerer parallel angeordneter imprägnierter Filamentstränge zu einer Gelegebahn aus parallel orientierten Filamenten (unidirektionales Gelege, im folgenden als UD-Gelege bezeichnet) mit einer definierten Dicke, dabei Härten des Binders durch Wärmebehandlung, so dass eine formstabile Gelegebahn definierter Dicke erhalten wird
- Schneiden der ggf. in einzelne Bänder aufgetrennten UD-Gelegebahn zu Segmenten (Faserbündeln) definierter Breite und Länge

Vorzugsweise werden die Filamentstränge vor der Imprägnierung aufgefächert, um die parallele Anordnung der Fasern nebeneinander in der Ebene zu erleichtern.
Der massebezogene Bindergehalt des Prepregs beträgt 25 bis 48 % und hängt von den gewählten Imprägnierungsbedingungen ab. Der Prepreg hat eine flächenbezogene Masse zwischen 200 und 500 g/m².
Der Prepreg in Form eines oder mehrerer nebeneinander angeordneter imprägnierter Filamentstränge wird durch einen Walzenstuhl, einen Kalander, eine Bandpresse oder eine andere geeignete kontinuierliche Pressvorrichtung geführt. In dieser Pressvorrichtung wird vorzugsweise durch mehrere hintereinander angeordnete Walzenspalt mit abnehmender lichter Weite die überschüssige Menge an Binder aus den Filamentsträngen heraus gedrückt, und die Stränge werden soweit flachgepresst, dass jeder Strang nicht mehr als drei übereinander liegende Faserlagen, und bevorzugt nur eine einzige Faserlage mit im wesentlichen parallel verlaufenden Filamenten umfasst. Die Verpressung des Prepregs erfolgt im warmen Zustand (bei Temperaturen bis 200 °C), so dass der carbonisierbaren Binder entweder aushärtet oder zumindest soweit härtet, dass formstabile Filamentstränge erhalten werden, in denen die Einzelfilamente in ihrer parallelen Anordnung neben- und übereinander fixiert sind.
Auch das Abkühlen der jetzt flachen, durch den gehärteten Binder gebundenen Filament-stränge erfolgt bevorzugt in der Pressvorrichtung, Beim Verlassen der kontinuierlichen Press-vorrichtung liegt eine flache Gelegebahn aus parallelen Filamenten (unidirektionales Gelege, im folgenden als "UD Gelege" bezeichnet) mit einer Dicke zwischen 0,15 und 0,4 mm vor. Die Gelegebahn kann, falls nötig, zur besseren Handhabbarkeit in Bänder mit einer Breite zwischen 20 und 60 mm aufgetrennt werden.
Die UD-Gelegebahnen oder -bänder werden nun der Länge nach zu Streifen geschnitten, deren Breite der gewünschten Breite der Faserbündel entspricht. Bevorzugt erfolgt dies mittels einer Schneidwalze oder mehrerer nebeneinander angeordneter Schneidwalzen. Es ist auch möglich, die Gelegebahn bzw. die Bänder im noch nicht vollständig gehärteten Zustand durch in den Bandweg gespannte Drähte in Streifen zu schneiden.
Die Streifen werden direkt einer bevorzugt kontinuierlich betriebenen Ablängeinrichtung zugeführt und zu Segmenten (Faserbündeln) der gewünschten Länge geschnitten. Es ist jedoch auch möglich, das Ablängen in einem vom Schneiden der Streifen getrennten Verfahren mit anderer Geschwindigkeit vorzunehmen. Zu diesem Zweck werden die auf die gewählte Breite geschnittenen Streifen auf Spulen aufgewickelt und zur Ablängeinrichtung transportiert. Das kontinuierliche Ablängen der Streifen auf die gewünschte Länge wird bevorzugt mit einer Messerwalze durchgeführt.
Die so erhaltenen Faserbündel zeichnen sich durch eine definierte, gleichmäßige Länge, Breite und Dicke aus. Die Bündeldicke, d.h. die Anzahl der übereinander liegenden Faser lagen, wurde beim Verpressen des Filamentstrangs zu einer Gelegebahn eingestellt. Die Bündelbreite, d.h. die von der Anzahl der in einer Faserlage parallel nebeneinander liegender Fasern bestimmte Dimension senkrecht zur Faserrichtung, wird beim Längsschneiden der Gelegebahn bzw. der Bänder zu Streifen eingestellt. Die Bündellänge, d.h. die Dimension in Faserrichtung, wird beim Ablängen der Streifen zu Segmenten (Faserbündeln) eingestellt. Mindestens 90 % der so hergestellten Faserbündel weisen eine Länge auf, die zwischen 90 und 110 % der mittleren Länge liegt, und eine Breite, die zwischen 90 und 110 % der mittleren Breite liegt.
Die so erhaltenen Faserbündel zeichnen sich durch eine sehr gute Handhabbarkeit aus, sie sind niesel- und schüttfähig und lassen sich leicht mit anderen Komponenten zu relativ homogenen Formmasse mischen. Innerhalb der Bündel werden die Fasern durch den formstabil gehärteten Binder zusammengehalten, so dass die Bündel bei der weiteren Verarbeitung nicht zerfallen können und die Fasern innerhalb der Bündel in ihrer parallelen räumlichen Anordnung fixiert sind.
Für das Verfahren der vorliegenden Erfindung besonders geeignet sind Faserbündel mit einer Dicke von 0,15 bis 0,4 mm, einer Länge von 6 bis 15 mm und einer Breite von 0,5 bis 3,5 mm. Feine Faserbündel, d.h. solche mit einer geringen Dicke (möglichst nur eine Faserlage) und einer geringen Breite (maximal 1 mm) sind bevorzugt, da sich damit eine besonders homogene Verteilung der Fasern in der Formmasse, und somit eine ziemlich gleichmäßige Dichte der Formmasse und ein besonders homogenes Gefüge des Formkörpers erreichen lässt. Je homogener das Gefüge des Formkörpers, desto geringer sind die Möglichkeiten für ein Versagen unter Belastung.

Die Faserbündel werden mit einem carbonisierbaren Matrixbildner und ggf. Hilfsstoffen zu einer Formmasse vermischt.
Unter carbonisierbarem Matrixbildner wird ein Kohlenstoff enthaltendes polymeres Material, beispielsweise ein Harz, verstanden, das bei Erhitzung in nichtoxidierender Atmosphäre einen im wesentlichen aus Kohlenstoff bestehenden Pyrolyserückstand bildet. Der carbonisierbare Matrixbildner kann als pulverförmiges Trockenharz oder als Nassharz vorliegen. Besonders geeignet als Matrixbildner sind Phenolharze. Der massebezogene Anteil der Faserbündel an der Formmasse beträgt 70 bis 80 %. Wird ein Trockenharz als Matrixbildner eingesetzt, so kann der Mischvorgang in einem Taumelmischer erfolgen. Bei Verwendung eines Nassharzes ist eine intensivere Durchmischung nötig, wie sie beispielsweise mit einem Eirich-Mischer erzielt werden kann.
Durch den formstabil gehärteten Binder in den Faserbündeln, welcher die parallel nebeneinander liegenden Fasern zusammenhält, wird erreicht, dass sich die Faserbündel beim Vermischen mit dem Matrixbildner nicht auflösen. So ist sichergestellt, dass die Faserbündel in der Formmasse eine weitgehend einheitliche definierte Länge Breite und Dicke aufweisen. Bei Bedarf können der Formmasse Hilfsstoffe beigemischt werden, wie beispielsweise Siliciumcarbid zur Verbesserung der tribologischen Eigenschaften, und oxidationshemmende Stoffe wie beispielsweise Zirconiumcarbid, Tantalcarbid oder Tantalborid, welche bei Sauerstoffzutritt durch Glasbildung den oxidativen Angriff hemmen. Der massebezogene Anteil der Hilfsstoffe an der Formmasse beträgt insgesamt maximal 10 %.

Gemäß einer vorteilhaften Weiterentwicklung des erfindungsgemäßen Verfahrens wird vor der Herstellung der Formmasse der in den Faserbündeln enthaltene carbonisierbare Binder zunächst carbonisiert, oder alternativ wird der Binder im UD-Gelege vor dem Schneiden der Bündel carbonisiert. Die so erhaltenen Bündel umfassen durch einem carbonisierten Binder zusammengehaltene, parallel ausgerichtete Carbonfasern. Wegen der bei der Carbonisierung erfolgten Volumenverminderung des Binders sind diese Bündel relativ offenporig, und können daher weiteren carbonisierbaren Matrixbildner direkt aufnehmen. Unter carbonisierbarem Matrixbildner wird ein Kohlenstoff enthaltendes polymeres Material, beispielsweise ein Phenolharz, verstanden, das bei Erhitzung in nichtoxidierender Atmosphäre einen im wesentlichen aus Kohlenstoff bestehenden Pyrolyserückstand bildet.
Um zu verhindern, dass die imprägnierten Faserbündel aufgrund des an ihren Oberflächen anhaftenden Harzes miteinander verkleben, erfolgt die Imprägnierung vorteilhaft in einem mechanisch erzeugten Wirbelbett. Dies kann mittels eines Schaufelmischers erzeugt werden. Dabei werden die Carbonfaserbündel zuerst unter Mischen mit einer Froude-Zahl kleiner 1 auf eine zur Härtung bzw. Trocknung des Harzes ausreichende Temperatur vorgeheizt. Anschließend wird unter kurzzeitiger Erhöhung der Froude-Zahl auf Werte zwischen 1,5 und 4, bevorzugt auf maximal 2,5, das Harz zudosiert und nach dessen Einmischung das Wirbelbett solange bei einer Froude-Zahl kleiner 1 gehalten, bis das Harz vollständig gehärtet oder getrocknet ist, so dass die Bündel nicht mehr miteinander verkleben können.
Bei dieser Imprägnierung können die Bündel aus durch einen carbonisierten Binder zusammengehaltenen, parallel ausgerichteten Carbonfasern bis zu 35 % ihrer eigenen Masse an carbonisierbarern Matrixbildner aufnehmen.
Weitere Details des Imprägnierungsprozesses sind aus der am gleichen Tag eingereichten Patentanmeldung verfahren zum Imprägnieren von Carbonfaserbündeln" desselben Anmelders zu entnehmen.
Aus den imprägnierten Faserbündeln, einem carbonisierbaren Matrixbildner und ggf. Hilfsstoffen wird in der vor stehend beschriebenen Art und Weise eine Formmasse hergestellt.

Aus der Formmasse wird mittels eines endkonturnah ausgelegten Presswerkzeugs ein Grünkörper mit der gewünschten Form, beispielsweise in Form einer Bremsscheibe, hergestellt. Das Pressen erfolgt typischerweise mit einem Druck im Bereich von 1,5 bis 5 N/mm² bei einer Temperatur zwischen 120 und 200 °C. Bevorzugt wird eine Warmfließpresse benutzt. Nach dem Aushärten wird das Werkzeug entformt und der endkontumake Grünkörper entnommen.

Im nächsten Schritt wird der carbonisierbare Matrixbildner im Grünkörper in eine Kohlenstoffmatrix umgewandelt, so dass ein carbonisierter Formkörper erhalten wird. Dazu wird der Grünkörper in einer Schutzgasatmosphäre, d.h. unter nichtoxidierenden Bedingungen, langsam auf eine Temperatur aufgeheizt, bei der die Pyrolyse des Matrixbildners zu einem im wesentlichen aus Kohlenstoff bestehenden Rückstand erfolgt, und eine bestimmte Zeit bei dieser Temperatur gehalten. Die Aufheizung muss hinreichend langsam erfolgen, um die Bildung von Rissen im Formkörper durch plötzliche Freisetzung gasförmiger Pyrolyseprodukte zu vermeiden. Typischerweise erfolgt die Aufheizung mit einer Geschwindigkeit um 1 K/min bis zu einer Temperatur von 900 °C, welche dann für ca eine Stunde gehalten wird. Anschließend wird der Körper langsam wieder auf Raumtemperatur abgekühlt. Bei der Carbonisierung erfährt der Formkörper durch die Abspaltung gasförmiger Pyrolyseprodukte aus dem Matrixbildner einen Masseverlust und dementsprechend eine Zunahme der Porosität. Typischerweise beträgt die Dichte des carbonisierten Formkörpers ca. 1,3 bis 1,45 g/cm³. Um den Masseverlust zu kompensieren, kann der carbonisierte Formkörper mit einem carbonisierbaren Matrixbildner (Harz oder Pech) nachimprägniert und dann erneut carbonisiert werden.

Der carbonisierte Formkörper kann mechanisch nachbearbeitet werden, soweit erforderlich. Beispielsweise können bei einer Bremsscheibe Kühlkanäle herausgearbeitet oder Bohrungen eingebracht werden.
Es ist jedoch auch möglich, derartige Formgebungen mittels verlorener Kerne bereits bei der Grünkörperherstellung vorzunehmen. Die Herstellung von Hohlräume enthaltenden Formkörpern im Pressverfahren mittels verlorener Kerne, deren äußere Abmessungen denen des herzustellenden Hohlraums entsprechen und die an den Positionen der herzustellenden Hohlräume in die Formmasse eingebracht werden, ist Stand der Technik. Die Kerne bestehen aus einem Material, das sich bei der Presstemperatur nahezu rückstandslos thermisch zersetzt und so den gewünschten Hohlraum hinterlässt.

Der poröse carbonisierte Formköiper wird durch Abscheidung einer Kohlenstoffmatrix mittels chemischer Gasphaseninfiltration (CVI) nachverdichtet, so dass seine Dichte auf Werte zwischen 1,6 und 1,8 g/cm³ steigt. Das Verfahren der Kohlenstoffabscheidung mittels chemischer Gasphaseninfiltration ist Stand der Technik. Ein geeignetes Kohlenstoffspendergas ist Methan.

Der für die Nachverdichtung mittels CVI benötigte Zeitaufwand kann um ca. 10 bis 30 % vermindert werden, wenn die Faserbündel vor dem Einmischen in die Formmasse mit einem carbonisierbaren Matrixbildner imprägniert werden, so dass ein dichtere Grünkörper erhalten wird. Auch die Nachimprägnierung des carbonisierten Formkörpers mit einem carbonisiert-baren Matrixbildner, der anschließend carbonisiert wird, bewirkt eine vergleichbare Verkürzung der für die CVI benötigten Zeit.

Die Orientierung der Faserbündel in den erfindungsgemäß hergestellten Formkörpern kann zufällig, d.h. statistisch verteilt, sein. Dies wird dann bevorzugt, wenn der Körper in allen Raunairichtungen einer annähernd gleichmäßigen Belastung ausgesetzt ist.
Für Formkörper, die in einer bestimmten Richtung eine besondere Belastung erfahren, ist jedoch eine belastungsgerechte Orientierung der Faserbündel erwünscht. Diese lässt sich durch einfache Maßnahmen beim Einfüllen der die Faserbündel enthaltenden Formmasse in das Presswerkzeug erreichen, beispielsweise durch Verwendung eines Befüllgitters.
Für Bremsscheiben ist es bevorzugt, die Faserbündel entsprechend der auftretenden Zugbelastung in tangentialer Richtung anzuordnen. Dazu wird ein Hefüllgitter verwendet, das mehrere konzentrisch angeordnete Ringe enthält.

### Ausführungsbeispiel

Eine Variante des erfindungsgemäßen Verfahrens wird anschließend beispielhaft anhand der Herstellung einer Bremsscheibe erläutert.

### Herstellung der Faserbündel

Jeweils 50.000 nahezu parallele Einzelfilamente umfassende Carbonfaserstränge werden mit einem Phenolharz (Narsophen 1203 der Fa. Hexion) imprägniert, so dass -ein- Prepreg mit einem massebezogenen Harzgehalt von 35 % und einem Flächengewicht von 320 g/m² entsteht

Dieser Prepreg wird kontinuierlich mit einer Geschwindigkeit von 1 m/min bei einem Druck von 1 MPa (10 bar) auf einer Bandpresse bei einer Temperatur von 180 °C zu einer Gelegebahn mit einer Dicke von 200 µm verdichtet und gleichzeitig soweit gehärtet, dass eine formstabile Gelegebahn erhalten wird.

Die UD-Gelegebahn wird nachfolgend in einzelne Bänder mit einer Breite von jeweils 50 mm aufgetrennt. Diese werden wie vorstehend beschrieben zu Segmenten (Faserbündeln) mit einer Länge von 9,4 mm und einer Breite von 1 mm zerschnitten.

### Herstellung der Formmasse

2400 g der Faserbündel werden in einen Taumelmischer überführt und mit 600 g Pulverharz (Phenolharz SP 227 der Firma Hexion als carbonisierbarer Matrixbildner) überschüttet und 5 Minuten lang miteinander vermischt

### Herstellen des Grünkörpers

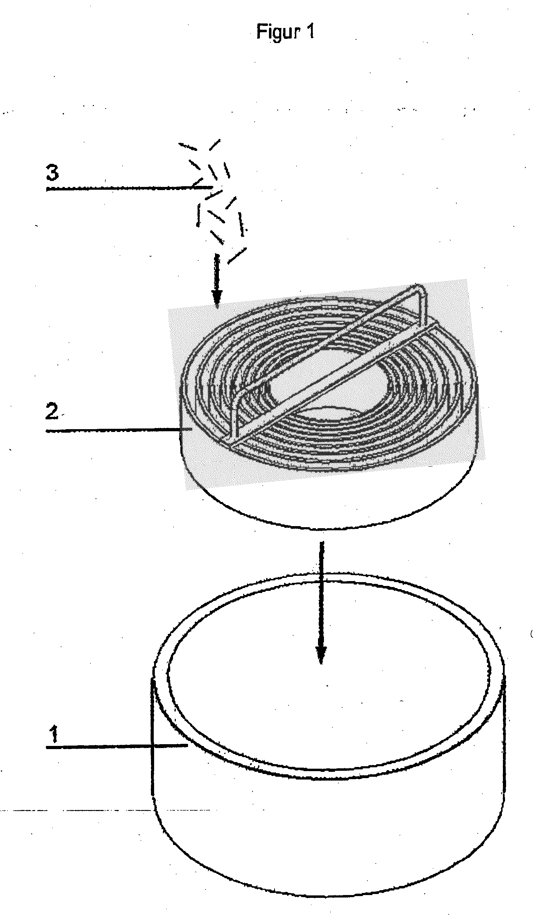

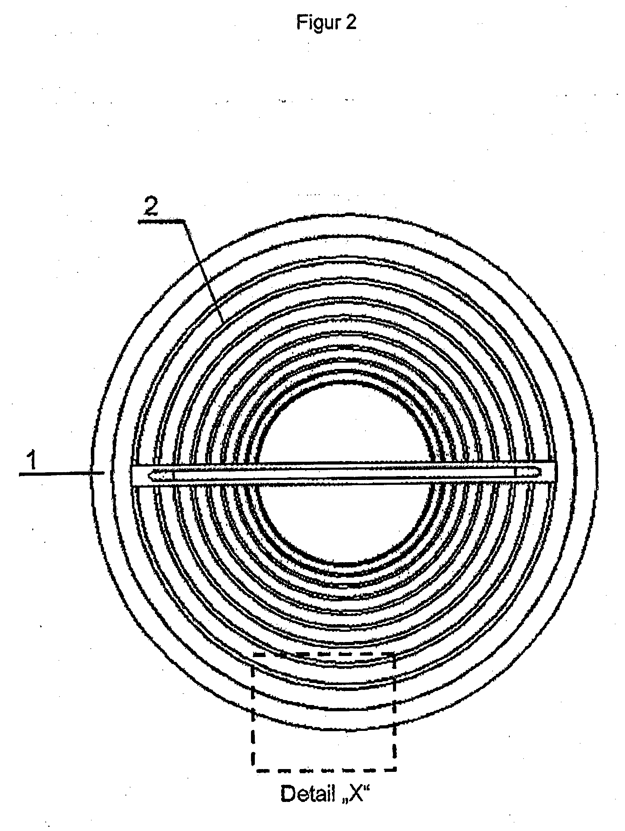

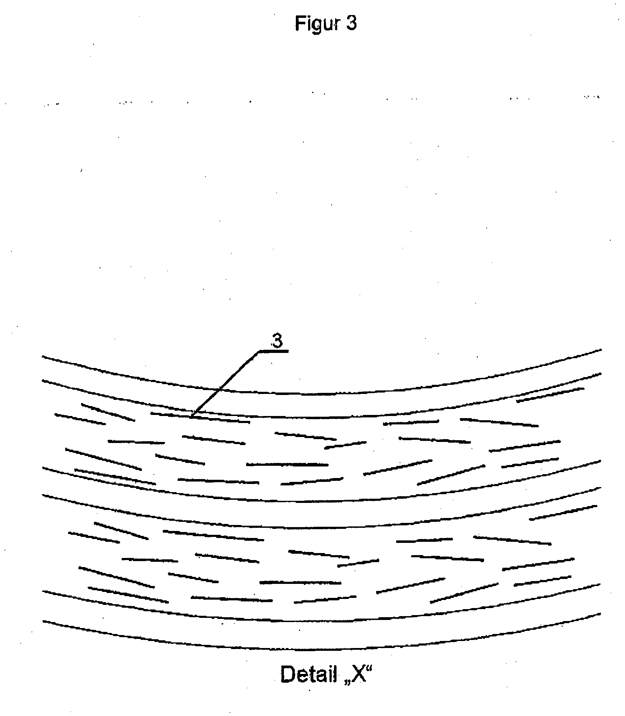

Der Befüllvorgang des Presswerkzeugs ist in Figur 1 schematisch dargestellt. Das Presswerkzeug 1, dessen Kavität der Geometrie der herzustellenden Bremsscheibe entspricht, wird mit der die Faserbündel 3 enthaltenden Formmasse befüllt. Um eine bevorzugt tangentiale Ausrichtung der Faserbündel 3 zu erzielen, wird ein Befüllgitter 2 verwendet, das mehrere konzentrische Ringe umfasst, deren Abstand kleiner oder gleich der Länge der Faserbündel 3 ist. Figur 2 zeigt schematisch, wie das Befüllgitter 2 auf dem Presswerkzeug 1 angeordnet ist. Beim Einfüllen fällt die Formmasse mit den Faserbündeln 3 durch die Zwischenräume zwischen den konzentrischen Ringen des Befüllgitters 2, und die Faserbündel, 3 nehmen die in Figur 3 schematisch dargestellte, im wesentlichen tangentiale Anordnung an. Das befüllte Presswerkzeug wird auf einer Warmfließpresse 30 Minuten einem Druck von 4,0 N/mm² und einer Temperatur von 160 °C ausgesetzt und anschließend entformt. Während des Pressvorgangs härtet das Phenolharz aus. Es wird ein endkontumaher Grünkörper in Form einer Bremsscheibe erhalten.

### Carbonisierung

Der Grünkörper wird in einen Schutzgasofen unter Stickstoffatmosphäre mit einer Aufheizgeschwindigkeit von 1 K/min auf eine Temperatur von 900°C erhitzt. Dabei werden die Phenolharze zu einem im wesentlichen aus Kohlenstoff bestehenden Rückstand zersetzt. Diese Temperatur wird eine Stunde gehalten. Danach wird der carbonisierte Formkörper auf Raumtemperatur abgekühlt.

### Nachverdichtung durch CVI

In dem porösen carbonisierte Formkörper wird durch chemische Gasphaseninfitration (CVI) eine Kohlenstoffmatrix abgeschieden. Die CVI erfolgt bei 1100 °C mit Methan als Kohlenstoffspender. Durch die Kohlenstoffabscheidung steigt die Dichte des carbonisierten Formkörpers von 1,3 auf 1,8 g/cm³.

### Charakterisierung der Bremsscheibe

Auf dem Schwungmassenprüfstand wurde ein Reibwert von µ = 0,5 bis 0,6 ermittelt.
Durch die tangentiale Orientierung der Faserbündel steigt die im Biegeversuch ermittelte Festigkeit der Bremsscheiben gegenüber Bremsscheiben mit zufälliger Anordnung der Faserbündel um 12 bis 20 %.

## Patentansprüche

1. Verfahren zur Herstellung von Formkörpern aus mit Carbonfaserbündeln verstärkter Kohlenstoffmatrix umfassend die folgenden Schritte
• Her- oder Bereitstellen von Bündeln aus durch einen formstabil gehärteten carbonisierbaren Binder zusammengehaltenen, parallel ausgerichteten Carbonfasern, wobei die Herstellung der Faserbündel erfolgt durch Tränken mindestens eines Filamentstrangs, der eine Vielzahl paralleler Carbonfaser-Filamente umfasst, mit einem carbonisierbaren Binder, so dass ein Prepreg erhalten wird und Pressen mindestens eines imprägnierten Filamentstrangs oder mehrerer parallel angeordneter imprägnierter Filamentstränge zu einer Gelegebahn aus parallel orientierten Filamenten (UD-Gelege) mit einer definierten Dicke, dabei Härten des Binders durch Wärmebehandlung, so dass eine formstabile Gelegebahn von definierter Dicke erhalten wird und Schneiden der ggf. in einzelne Bänder aufgetrennten UD-Gelegebahn zu Segmenten (Faserbündeln) definierter Breite und Länge und wobei die Bündel eine gezielt eingestellte, definierte Länge, Breite und Dicke haben
• Herstellung einer Formmasse durch Mischen der Faserbündel, eines carbonisierbaren Matrixbildners und optionaler Hilfsstoffe
• Herstellung eines endkonturnahen Grünkörpers durch Verpressen der Formmasse in einem endkonturnahen Presswerkzeug bei erhöhter Temperatur unter Aushärten des carbonisierbaren Matrixbildners, anschließendes Entformen
• Carbonisierung des Grünkörpers zu einem carbonisieren Formkörper
• mechanische Nachbearbeitung des carbonisierten Formkörpers, falls erforderlich
• Verdichtung des carbonisierten Formkörpers durch Abscheidung einer Kohlenstoff matrix mittels CVI-Verfahren.

2. Verfahren nach Anspruch 1, **dadurch gekennzeichnet, dass**
der Binder in den im ersten Schritt her- oder bereitgestellten Faserbündeln carbonisiert ist und die Faserbündel vor der Herstellung der Formmasse in einem mechanisch erzeugten Wirbelbett mit einen carbonisierbaren Matrixbildner nachimprägniert werden.

3. Verfahren nach Anspruch 1 oder 2, **dadurch gekennzeichnet, dass**
die Dicke der Faserbündel auf einen Wert zwischen 0,15 und 0,4 mm, die Länge der Faserbündel auf einen Wert zwischen 6 bis 15 mm und die Breite der Faserbündel auf einen Wert zwischen 0,5 bis 3,5 mm eingestellt ist.

4. Verfahren nach Anspruch 3, **dadurch gekennzeichnet, dass**
die Breite der Faserbündel 1 mm beträgt.

5. Verfahren nach Anspruch 1 oder 2, **dadurch gekennzeichnet, dass**
der carbonisierbare Matrixbildner ein Phenolharz ist.

6. Verfahren nach Anspruch 1 oder 2, **dadurch gekennzeichnet, dass**
der massebezogene Anteil der Faserbündel an der Formmasse 70 bis 80 % beträgt.

7. Verfahren nach Anspruch 1 oder 2, **dadurch gekennzeichnet, dass**
die Formmasse einen massebezogenen Anteil von maximal 10 % an Hilfsstoffen enthält.

8. Verfahren nach Anspruch 7, **dadurch gekennzeichnet, dass**
mindestens einer der folgenden Hilfsstoffe enthalten ist: tribologisch Hilfsstoffe wie Siliciumcarbid, oxidationshemmende Stoffe wie Zirconiumcarbid, Tantalcarbid oder Tantalborid,

9. Verfahren nach Anspruch 1 oder 2, **dadurch gekennzeichnet, dass**
die Formmasse durch ein Befüllgitter in das Presswerkzeug eingefüllt wird, so dass die Faserbündel eine durch das Befüllgitter vorgegebene Ausrichtung annehmen,

10. Verfahren nach Anspruch 1 oder 2, **dadurch gekennzeichnet, dass**
die Herstellung des Grünkörpers mittels eines endkonturnah ausgelegten Presswerkzeug bei einem Druck im Bereich von 1,5 bis 5 N/mm² und einer Temperatur zwischen 120 und 200 °C in einer Warmfließpresse erfolgt.

11. Verfahren nach Anspruch 1 oder 2, **dadurch gekennzeichnet, dass**
der carbonisierte Formkörper vor der chemischen Gasphaseninfiltration mit einem carbonisierbaren Matrixbildner nachimprägniert und danach erneut carbonisiert wird.

12. Verfahren nach Anspruch 11, **dadurch gekennzeichnet, dass**
der für die Nachimprägnierung des carbonisierten Formkörpers verwendete carbonisierten Matrixbildner ein Harz oder Pech ist.

13. Verfahren nach Anspruch 1 oder 2, **dadurch gekennzeichnet, dass**
bei der chemischen Gasphaseninfiltration Methan als Kohlenstoffspender eingesetzt wird.

14. Verfahren nach Anspruch 1 oder 2,
**dadurch gekennzeichnet, dass** der Formkörper eine Bremsscheibe ist.

15. Verfahren nach Anspruch 14, **dadurch gekennzeichnet, dass**
die Formmasse durch ein Befüllgitter, das mehrere konzentrische Ringe enthält, in das Presswerkzeug eingefüllt wird, so dass die Faserbündel eine tangentiale Ausrichtung annehmen.

16. Formkörper aus mit Carbonfaserbündeln verstärktem Kohlenstoff herstellbar nach dem Verfahren gemäß Anspruch 1, dessen Kohlenstoffmatrix den Pyrolyserückstand eines carbonisierbaren Matrixbildners und mittels chemischer Gasphaseninfiltration (CVI) abgeschiedenen Kohlenstoffumfasst, **dadurch gekennzeichnet, dass**
die Carbonfasern in Bündeln mit gezielt eingestellten, definierten Dimensionen vorliegen, wobei die Dicke der Bündel auf einen Wert zwischen 0,15 und 0,4 mm, die Länge der Bündel auf einen Wert zwischen 6 und 15 mm und die Breite der Bündel auf einen Wert zwischen 0,5 und 3,5 mm eingestellt worden ist, und
die Carbonfasern in den Bündeln parallel ausgerichtet sind,

17. Formkörper nach Anspruch 16, **dadurch gekennzeichnet, dass**
die Breite der Faserbündel 1 mm beträgt.

18. Formkörper nach Anspruch 16 oder 17, **dadurch gekennzeichnet, dass**
die Orientierung der Faserbündel im Formkörper zufällig ist.

19. Formkörper nach Anspruch 16 oder 17, **dadurch gekennzeichnet, dass**
die Faserbündel im Formkörper entsprechend einer Belastungsrichtung des Formkörpers ausgerichtet sind.

20. Fonnkörper nach Anspruch 16 oder 17, **dadurch gekennzeichnet, dass**
der Formkörper eine Bremsscheibe ist, in welcher die Faserbündel tangential angeordnet sind.

## Claims

1. Method for producing mouldings from a carbon matrix reinforced with carbon fibre bundles, comprising the following steps:
• producing or providing bundles of parallel carbon fibres held together by a dimensionally stable cured, carbonisable binder, wherein the fibre bundles are produced by impregnating at least one filament strand, which comprises a plurality of parallel carbon fibre filaments, with a carbonisable binder to produce a prepreg, and by compressing at least one impregnated filament strand or a plurality of impregnated filament strands arranged in parallel in order to form a fabric web consisting of parallel filaments (UD fabric) having a defined thickness, and in the process curing the binder by heat treatment so as to obtain a dimensionally stable fabric web of a defined thickness, and of cutting the UD fabric web, which may optionally be cut into individual strips, to form segments (fibre bundles) of a defined width and length, and wherein the bundles have a specifically set, defined length, width and thickness
• producing a moulding composition by mixing the fibre bundles, a carbonisable matrix former and optional auxiliaries
• producing a green body that is close to a final contour by compressing the moulding composition in a compression mould that is close to the final contour at a high temperature, thus curing the carbonisable matrix former, and subsequently removing said body from the compression mould
• carbonising the green body to form a carbonised moulding
• mechanically re-working the carbonised moulding, if necessary
• compacting the carbonised moulding by depositing a carbon matrix by means of CVI methods.

2. Method according to claim 1, **characterised in that** the binder is carbonised in the fibre bundles produced or provided in the first step and the fibre bundles are re-impregnated with a carbonisable matrix former in a mechanically generated fluidised bed before the moulding composition is produced.

3. Method according to either claim 1 or claim 2, **characterised in that** the thickness of the fibre bundles is set to a value of between 0.15 and 0.4 mm, the length of the fibre bundles is set to a value of between 6 and 15 mm, and the width of the fibre bundles is set to a value of between 0.5 and 3.5 mm.

4. Method according to claim 3, **characterised in that** the width of the fibre bundles is 1 mm.

5. Method according to either claim 1 or claim 2, **characterised in that** the carbonisable matrix former is a phenolic resin.

6. Method according to either claim 1 or claim 2, **characterised in that** the proportion by mass of the fibre bundles in the moulding composition is from 70 to 80 %.

7. Method according to either claim 1 or claim 2, **characterised in that** the moulding composition contains at most 10% by mass of auxiliaries,

8. Method according to claim 7, **characterised in that** said moulding composition contains at least one of the following auxiliaries: tribological auxiliaries such as silicon carbide, oxidation-inhibiting substances such as zirconium carbide, tantalum carbide or tantalum boride.

9. Method according to either claim 1 or claim 2, **characterised in that** the moulding composition is poured into the compression mould through a charging grate, causing the fibre bundles to assume an alignment determined by the charging grate.

10. Method according to either claim 1 or claim 2, **characterised in that** the green body is produced in a hot extrusion press by means of a compression mould that is close to the final contour, at a pressure in the range of from 1.5 to 5 N/mm² and a temperature of between 120 and 200 °C.

11. Method according to either claim 1 or claim 2, **characterised in that** the carbonised moulding is re-impregnated with a carbonisable matrix former and then carbonised again before the chemical vapour Infiltration method.

12. Method according to claim 11, **characterised in that** the carbonised matrix former used to re-impregnate the carbonised moulding is a resin or pitch.

13. Method according to either claim 1 or claim 2, **characterised in that** methane is used as a carbon donor during chemical vapour infiltration.

14. Method according to either claim 1 or claim 2, **characterised in that** the moulding is a brake disc.

15. Method according to claim 14, **characterised in that** the moulding composition is poured into the compression mould through a charging grate containing a plurality of concentric rings, causing the fibre bundles to assume a tangential alignment.

16. Moulding consisting of carbon reinforced with carbon fibre bundles, producible according to the method according to claim 1, the carbon matrix of which moulding comprises a pyrolysis residue of a carbonisable matrix former and carbon deposited by chemical vapour infiltration (CVI), **characterised in that** the carbon fibres are in bundles having specifically set, defined dimensions, the thickness of the bundles having been set to a value of between 0,15 and 0.4 mm, the length of the bundles having been set to a value of between 6 and 15 mm, and the width of the bundles having been set to a value of between 0.5 and 3.6 mm, and the carbon fibres are aligned in the bundles in parallel with one another.

17. Moulding according to claim 16, **characterised in that** the width of said fibre bundles is 1 mm.

18. Moulding according to either claim 16 or claim 17, **characterised in that** the fibre bundles are oriented in the moulding in a random manner.

19. Moulding according to either claim 16 or claim 17, **characterised in that** the fibre bundles are aligned in the moulding according to a loading direction of the moulding.

20. Moulding according to either claim 16 or claim 17, **characterised in that** the moulding is a brake disc in which said fibre bundles are arranged tangentially.

## Revendications

1. Procédé de fabrication de corps moulés à partir d'une matrice de carbone renforcée de faisceaux de fibres de carbone, comprenant les étapes suivantes :
• fabrication ou fourniture de faisceaux de fibres de carbone orientées parallèlement, retenues ensemble par un liant carbonisable durci de façon formellement stable, où la fabrication des faisceaux de fibres s'effectue par imprégnation d'au moins un toron de filaments, qui comprend une multiplicité de filaments parallèles de fibres de carbone, avec un liant carbonisable de telle sorte qu'un prépreg est obtenu, et pressage d'au moins un toron de filaments imprégné ou de plusieurs torons de filaments imprégnés disposés parallèlement pour donner une bande de grille de filaments orientés parallèlement (grille UD) avec une épaisseur définie, au même temps durcissement du liant par traitement thermique de telle sorte qu'une bande de grille formellement stable d'une épaisseur définie est obtenue, et découpe de la bande de grille UD séparée éventuellement en rubans individuels pour donner des segments (faisceaux de fibres) de largeur et de longueur définies, et où les faisceaux ont une longueur, une largeur et une épaisseur définies réglées de façon ciblée
• fabrication d'une matière à mouler par mixage des faisceaux de fibres, d'un agent carbonisable formant la matrice et d'adjuvants optionnels
• fabrication d'un corps de base présentant un contour proche du contour final par compression de la matière à mouler dans un outil de presse présentant un contour proche du contour final à température élevée en présence d'un durcissement de l'agent carbonisable formant la matrice, puis démoulage
• carbonisation du corps de base pour donner un corps moulé carbonisé
• post-traitement mécanique du corps moulé carbonisé, si nécessaire
• compactage du corps moulé carbonisé par séparation d'une matrice de carbone au moyen de procédés CVI.

2. Procédé selon la revendication 1, **caractérisé en ce que** le liant est carbonisé dans les faisceaux de fibres fabriqués ou fournis dans la première étape et, avant la fabrication de la matière à mouler, les faisceaux de fibres sont réimprégnés dans un lit fluidisé produit mécaniquement, avec un agent carbonisable formant la matrice.

3. Procédé selon la revendication 1 ou 2, **caractérisé en ce que** l'épaisseur des faisceaux de fibres est réglée à une valeur comprise entre 0,15 et 0,4 mm, la longueur des faisceaux de fibres à une valeur comprise entre 6 et 15 mm, et la largeur des faisceaux de fibres à une valeur comprise entre 0,5 et 3,5 mm.

4. Procédé selon la revendication 3, **caractérisé en ce que** la largeur des faisceaux de fibres est égale à 1 mm.

5. Procédé selon la revendication 1 ou 2, **caractérisé en ce que** l'agent carbonisable formant la matrice est une résine phénolique.

6. Procédé selon la revendication 1 ou 2, **caractérisé en ce que** la fraction, rapportée à la masse, des faisceaux de fibres dans la matière à mouleur est comprise entre 70 et 80%.

7. Procédé selon la revendication 1 ou 2, **caractérisé en ce que** la matière à mouler contient une fraction, rapportée à la masse, d'adjuvants de 10% maximum.

8. Procédé selon la revendication 7, **caractérisé en ce que** au moins un des adjuvants suivants est contenu : adjuvants tribologiques tels le carbure de silicium, des substances antioxydants telles que le carbure de zirconium, le carbure de tantale ou le borure de tantale.

9. Procédé selon la revendication 1 ou 2, **caractérisé en ce que** la matière à mouler est introduite dans l'outil de presse par un treillis de remplissage de telle sorte que les faisceaux de fibres adoptent une orientation prédéfinie par le treillis de remplissage.

10. Procédé selon la revendication 1 ou 2, **caractérisé en ce que** la fabrication du corps de base s'effectue au moyen d'un outil de presse conçu avec un contour proche du contour final en présence d'une pression dans la plage de 1,5 à 5 N/mm² et d'une température comprise entre 120 et 200 °C dans une presse d'extrusion à chaud.

11. Procédé selon la revendication 1 ou 2, **caractérisé en ce que** le corps moulé carbonisé est réimprégné avant l'infiltration chimique en phase gazeuse avec un agent carbonisable formant la matrice et puis carbonisé de nouveau.

12. Procédé selon la revendication 11. **caractérisé en ce que** l'agent carbonisé formant la matrice utilisé pour la réimprégnation du corps moulé carbonisé est une résine ou un brai.

13. Procédé selon la revendication 1 ou 2, **caractérisé en ce que**, lors de l'infiltration chimique en phase gazeuse, il est utilisé un méthane en tant que source de carbone.

14. Procédé selon la revendication 1 ou 2, **caractérisé en ce que** le corps moulé est un disque de frein.

15. Procédé selon la revendication 14, **caractérisé en ce que** la matière à mouler est introduite dans l'outil de presse par un treillis de remplissage qui possède plusieurs anneaux concentriques de telle sorte que les faisceaux de fibres adoptent une orientation tangentielle.

16. Corps moulé en matière plastique renforcée de faisceaux de fibres de carbone pouvant être fabriqué suivant le procédé selon la revendication 1, dont la matrice de carbone comprend le résidu de pyrolyse d'un agent carbonisable formant la matrice et du carbone séparé au moyen de l'infiltration chimique en phase gazeuse (CVI), **caractérisé en ce que** les fibres de carbone se présentent en faisceaux ayant des dimensions définies réglées de façon ciblée, où l'épaisseur des faisceaux a été réglée à une valeur comprise entre 0,15 et 0,4 mm, la longueur des faisceaux à une valeur comprise entre 6 et 15 mm et la largeur des faisceaux à une valeur comprise entre 0,5 et 3,5 mm, et les fibres de carbone dans les faisceaux sont orientées parallèlement.

17. Corps moulé selon la revendication 16, **caractérisé en ce que** la largeur des faisceaux de fibres est égale à 1 mm.

18. Corps moulé selon la revendication 16 ou 17, **caractérisé en ce que** l'orientation des faisceaux de fibres dans le corps moulé est aléatoire.

19. Corps moulé selon la revendication 16 ou 17, **caractérisé en ce que** les faisceaux de fibres dans le corps moulé sont orientés conformément à une direction de charge du corps moulé.

20. Corps moulé selon la revendication 6 ou 17, **caractérisé en ce que** le corps moulé est un disque de frein dans lequel les faisceaux de fibres sont disposés de façon tangentielle.
